# EUROPEAN PATENT APPLICATION

(11) **EP 4 481 014 A1**
(43) Date of publication of application: **25.12.2024**
(21) Application number: 24164782.5
(22) Date of filing: 20.03.2024
(51) Int. Cl.: C09K 13/00, C23F 1/16, C23F 1/26, C23F 3/06, H01L 21/3213

(54) **ETCHING COMPOSITION, METAL-CONTAINING FILM ETCHING METHOD USING THE SAME AND SEMICONDUCTOR DEVICE MANUFACTURING METHOD USING THE SAME**

(30) Priority: 24.03.2023 KR 20230039198; 02.06.2023 KR 20230071898
(71) Applicant: Samsung Electronics Co., Ltd., Suwon-si, Gyeonggi-do 16677 (KR)
(72) Inventor: HWANG, Kyuyoung, 16678 Suwon-si (KR); KANG, Byungjoon, 16678 Suwon-si (KR); KIM, Daihyun, 18448 Hwaseong-si (KR); KIM, Sungmin, 16678 Suwon-si (KR); PARK, Mihyun, 18448 Hwaseong-si (KR); OH, Jungmin, 18448 Hwaseong-si (KR); HAM, Cheol, 18448 Suwon-si (KR)
(74) Representative: Elkington and Fife LLP

(57) **Abstract**

An etching composition may include an oxidizer, an ammonium salt, an aqueous solvent, and an accelerator. A method of etching a metal-containing film may be performed using the etching composition, and a method of manufacturing a semiconductor device may be performed using the etching composition.

## Description

### FIELD OF THE INVENTION

The disclosure relates to an etching composition, a method of etching a metal-containing film by using the etching composition, and a method of manufacturing a semiconductor device by using the etching composition.

### BACKGROUND OF THE INVENTION

Semiconductor devices are becoming more integrated and reliable to meet consumer demand for high performance and low prices. As the degree of integration of semiconductors increases, the reliability and electrical characteristics of semiconductor devices may be influenced more by damage to the elements constituting the semiconductor device during the process of manufacturing the semiconductor device. In particular, in the process of manufacturing semiconductor devices, various etching processes may be performed on a certain film (for example, a metal-containing film), and in order to perform the etching process effectively, there may be a continuous need for etching compositions that may provide an excellent etching rate, excellent etching selectivity to adjacent films, no surface residue after etching, excellent storage stability, etc.

### SUMMARY OF THE INVENTION

Provided is an etching composition that may increase the productivity and efficiency of an etching process while having excellent etching selectivity for a metal-containing film to be etched.

Additional aspects will be set forth in part in the description which follows and, in part, will be apparent from the description, or may be learned by practice of the presented embodiments of the disclosure.

According to an embodiment of the disclosure, an etching composition may include an oxidizer, an ammonium salt, an aqueous solvent, and an accelerator, wherein the ammonium salt may include an ammonium cation and an organic anion, the accelerator may include a first accelerator and a second accelerator, the first accelerator and the second accelerator may be different from each other, and each of the first accelerator and the second accelerator may include at least one of a group represented by Formula A below, a group represented by Formula B below, and a group represented by Formula C below: 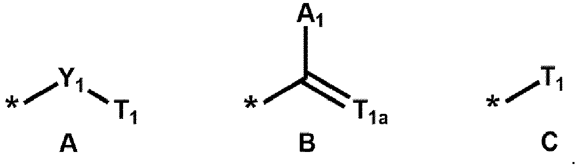 In Formula A to Formula C,
Y₁ may be C(Z₃)(Z₄), N(Z₃), C(=O), C(=S), S(=O)₂, or P(=O)(Z₃),
T₁ may be *-OH, *-SH, or *-NH₂,
T₁ₐ may be O or S,
Z₃ and Z₄ each independently may be
   hydrogen, deuterium, *-F, *-CI, *-Br, *-I, *-OH, *-SH, *-NH₂, *-C(=O)H, *-C(=S)H, *-C(=O)-OH, *-C(=S)-OH, *-C(=O)-SH, *-C(=S)-SH, *-C(=O)-(NH₂), *-C(=S)-(NH₂), *-NH-C(=O)-(NH₂), *-NH-C(=S)-(NH₂), *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH, *-C(=S)-C(=S)-SH, or *-C(=O)-ONH₄, or
   a C₁-C₂₀ alkyl group, a C₂-C₂₀ alkenyl group, a C₁-C₂₀ alkoxy group, a C₆-C₂₀ aryl group, a C₂-C₂₀ heteroaryl group, a C₇-C₂₀ arylalkyl group, or a C₃-C₂₀ heteroarylalkyl group, each unsubstituted or substituted with deuterium, *-F, *-Cl, *-Br, *-I, *-OH, *-SH, *-NH₂, *-C(=O)H, *-C(=S)H, *-C(=O)-OH, *-C(=S)-OH, *-C(=O)-SH, *-C(=S)-SH, *-C(=O)-(NH₂), *-C(=S)-(NH₂), *-NH-C(=O)-(NH₂), *-NH-C(=S)-(NH₂), *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH, *-C(=S)-C(=S)-SH, *-C(=O)-ONH₄, or any combination thereof,
A₁ may be
   hydrogen or deuterium, or
   a C₁-C₂₀ alkyl group, a C₂-C₂₀ alkenyl group, a C₁-C₂₀ alkoxy group, a C₆-C₂₀ aryl group, a C₂-C₂₀ heteroaryl group, a C₇-C₂₀ arylalkyl group, or a C₃-C₂₀ heteroarylalkyl group, each unsubstituted or substituted with deuterium, *-F, *-CI, *-Br, *-I, a C₁-C₂₀ alkyl group, a C₁-C₂₀ alkoxy group, or any combination thereof, and
* may be binding site to any atom of the first accelerator and any atom of the second accelerator.

In some embodiments,
i) the first accelerator and the second accelerator each may be a first compound, ii) one of the first accelerator and the second accelerator may be the first compound and the other of the first accelerator and the second accelerator may be a second compound, or iii) the first accelerator and the second accelerator each may be the second compound,

the first compound may be a compound capable of forming a cyclometallated 5-membered ring or a cyclometallated 6-membered ring, which comprises a metal or metal ion combined with at least one of O, S, and N, and
the second compound may be a compound incapable of forming the cyclometallated 5-membered ring and the cyclometallated 6-membered ring.

In some embodiments, the first compound may be a compound represented by one of Formula 1-1 to Formula 1-6 and Formula 2-1 to Formula 2-8 below:

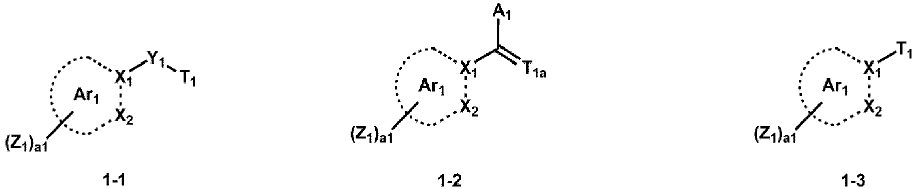

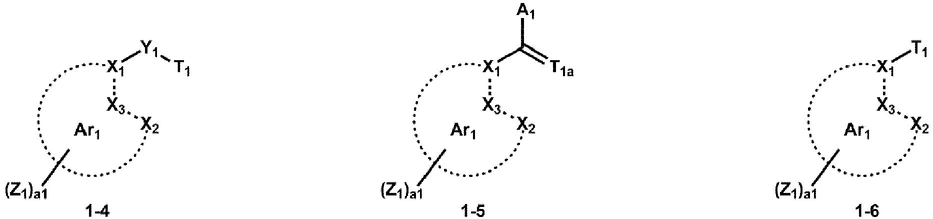

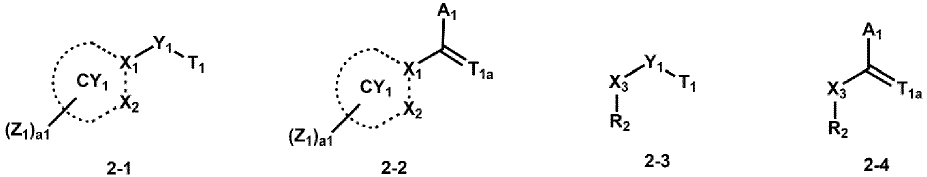

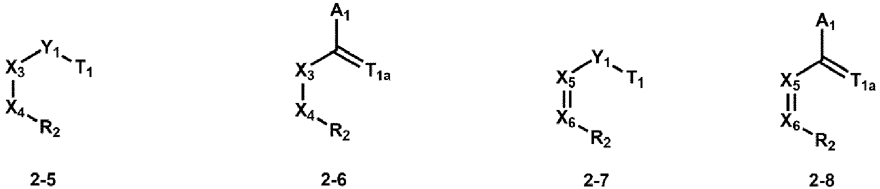

The description of each of the Formula 1-1 to Formula 1-6 and Formula 2-1 to Formula 2-8 is the same as those described in the present specification.

In some embodiments, the second compound may be a compound represented by one of Formula 3-1 to Formula 3-5 below:

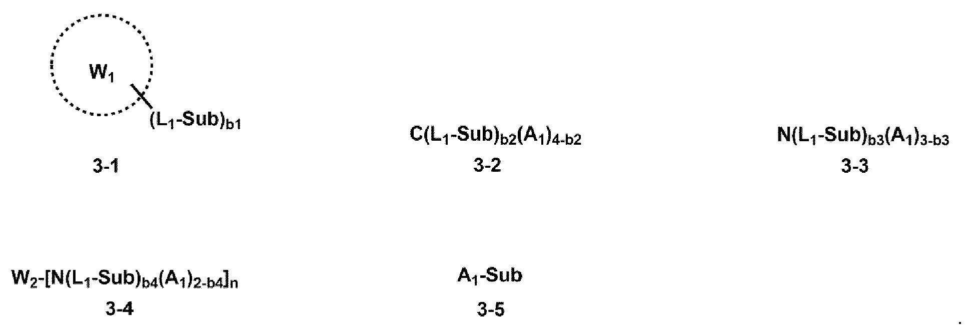

The Formula 3-1 to Formula 3-5 are respectively the same as those described in the present specification.

In some embodiments, the accelerator may further include, in addition to the first accelerator and the second accelerator, another accelerator.

In some embodiments, a weight ratio of the first accelerator to the second accelerator may be from 1:99 to 99:1.

In some embodiments, an amount of the accelerator may be from about 0.001 wt% to about 20 wt%, per 100 wt% of the etching composition.

According to an embodiment of the disclosure, a method of etching a metal-containing film may include preparing a substrate on which a metal-containing film is provided, and performing an etching process using the etching composition on the metal-containing film to remove at least a portion of the metal-containing film.

In some embodiments, the metal-containing film may include indium (In), titanium (Ti), aluminum (Al), lanthanum (La), scandium (Sc), gallium (Ga), zinc (Zn), hafnium (Hf), or any combination thereof.

In some embodiments, the metal-containing film may include a metal nitride, a metal oxide, a metal oxynitride, or a combination thereof.

In some embodiments, the metal-containing film may include a first region and a second region. A second etching rate at which the etching composition etches the second region may be greater than a first etching rate at which the etching composition etches the first region. The etching process may be performed by contacting at least a portion of the first region and at least a portion of the second region with the etching composition.

In some embodiments, the etching composition may etch at least a portion of the first region and at least a portion of the second region, respectively.

According to an embodiment of the disclosure, a method of manufacturing a semiconductor device may include preparing a substrate on which a metal-containing film is provided, and performing an etching process using the etching composition on the metal-containing film to remove at least a portion of the metal-containing film.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a process flow diagram of an embodiment of a method of manufacturing a semiconductor device; and
FIG. 2 and FIG. 3 are diagrams illustrating an embodiment of a method of etching a metal-containing film.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, "at least one of A, B, and C," and similar language (e.g., "at least one selected from the group consisting of A, B, and C") may be construed as A only, B only, C only, or any combination of two or more of A, B, and C, such as, for instance, ABC, AB, BC, and AC.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

### Etching target film

A film to be etched may include a metal-containing film.

Therefore, an etching composition may be used in an etching process and/or a chemical mechanical polishing (CMP) process for the metal-containing film.

The metals included in the metal-containing film may include alkali metals (for example, sodium (Na), potassium (K), rubidium (Rb), cesium (Cs), etc.), alkaline earth metals (for example, beryllium (Be), magnesium (Mg), calcium (Ca), strontium (Sr), barium (Ba), etc.), lanthanum group metals (for example, lanthanum (La), europium (Eu), terbium (Tb), ytterbium (Yb), etc.), transition metals (for example, scandium (Sc), yttrium (Y), titanium (Ti), zirconium (Zr), hafnium (Hf), vanadium (V), niobium (Nb), tantalum (Ta), chromium (Cr), molybdenum (Mo), tungsten (W), manganese (Mn), iron (Fe), ruthenium (Ru), osmium (Os), cobalt (Co), rhodium (Rh), nickel (Ni), copper (Cu), silver (Ag), zinc (Zn), etc.), post-transition metals (for example, aluminum (Al), gallium (Ga), indium (In), thallium (TI), tin (Sn), bismuth (Bi), etc.), or any combination thereof.

According to an embodiment, the metal-containing film may include indium (In), titanium (Ti), aluminum (Al), copper (Cu), tungsten (W), cobalt (Co), lanthanum (La), scandium (Sc), gallium (Ga), zinc (Zn), hafnium (Hf), or any combination thereof.

According to another embodiment, the metal-containing film may include indium (In), titanium (Ti), aluminum (Al), lanthanum (La), scandium (Sc), gallium (Ga), zinc (Zn), hafnium (Hf), or any combination thereof.

For example, the metal-containing film may include aluminum, titanium, lanthanum, or any combination thereof.

According to another embodiment, the metal-containing film may include aluminum.

According to another embodiment, the metal-containing film may include titanium.

According to another embodiment, the metal-containing film may include titanium and aluminum.

The metal-containing film may include a metal nitride, a metal oxide, a metal oxynitride, or any combination thereof.

The metal-containing film may include a metal nitride, a metal oxide, a metal oxynitride, or any combination thereof, wherein the metal included in each of the metal nitride, the metal oxide, and the metal oxynitride may include indium (In), titanium (Ti), aluminum (Al), lanthanum (La), scandium (Sc), gallium (Ga), zinc (Zn), hafnium (Hf), or any combination thereof.

The metal-containing film may include a metal nitride. The metal included in the metal nitride may include indium, titanium, aluminum, lanthanum, scandium, gallium, zinc, hafnium, or any combination thereof.

For example, the metal-containing film may include titanium nitride. The titanium nitride may further include indium, aluminum, lanthanum, scandium, gallium, hafnium, zinc, or any combination thereof. According to another embodiment, the metal-containing film may include titanium nitride (TiN), titanium nitride further including aluminum (for example, titanium/aluminum nitride or TiAIN), titanium nitride further including lanthanum, etc.

According to another embodiment, the metal-containing film may include a metal oxide. The metal included in the metal oxide may include titanium, aluminum, lanthanum, scandium, gallium, hafnium, or any combination thereof. For example, the metal-containing film may include aluminum oxide (for example, Al₂O₃), indium gallium zinc oxide (IGZO), etc.

According to another embodiment, the metal-containing film may include the metal nitride and the metal oxide.

According to another embodiment, the metal-containing film may further include, in addition to metals, metalloids (for example, boron (B), silicon (Si), germanium (Ge), arsenic (As), antimony (Sb), tellurium (Te), etc.), non-metals (for example, nitrogen (N), phosphorus (P), oxygen (O), sulfur (S), selenium (Se), etc.), or any combination thereof.

For example, the metal-containing film may further include silicon oxide.

The metal-containing film may have a single-layer structure consisting of (or including) one or more substances, or may have a multi-layer structure or patterned structure including different substances. For example, the metal-containing film may have i) a single-layer structure consisting of (or including) titanium nitride, ii) a two-layer structure or patterned structure having a first layer consisting of (or including) titanium nitride and a second layer consisting of (or including) titanium nitride with additional aluminum, or iii) a two-layer structure or patterned structure having a first layer consisting of (or including) titanium nitride and a second layer consisting of (or including) aluminum oxide.

According to another embodiment, the metal-containing film may include a first region and a second region, wherein a second etching rate at which an etching composition etches the second region may be greater than a first etching rate at which an etching composition etches the first region. During an etching process and/or a polishing process for the metal-containing film, at least a portion of the first region and at least a portion of the second region may be in contact with an etching composition, and the second etching rate may be greater than the first etching rate, such that the second region may be etched faster than the first region.

For example, the first region may include at least one of a metal oxide (for example, an aluminum oxide) and a silicon oxide.

According to another embodiment, the second region may include a metal nitride.

According to another embodiment, the second region may include i) titanium nitride, ii) titanium nitride further including indium, aluminum, lanthanum, scandium, gallium, zinc, hafnium, or any combination thereof, or iii) a combination thereof.

According to another embodiment, each of the first region and second region may include, i) titanium nitride, ii) titanium nitride further including indium, aluminum, lanthanum, scandium, gallium, zinc, hafnium, or any combination thereof, or iii) a combination thereof.

According to another embodiment, the first region may include aluminum, and the second region may not include aluminum.

According to another embodiment, the first region may include titanium nitride further including aluminum (for example, titanium/aluminum nitride or TiAIN), and the second region may include titanium nitride (TiN).

According to another embodiment, the first region may include a titanium nitride film further including aluminum (for example, a titanium/aluminum nitride film or TiAIN film), and the second region may include a titanium nitride film (TiN film).

According to another embodiment, the first region may be a titanium nitride film further including aluminum (for example, a titanium/aluminum nitride film or TiAIN film), and the second region may be a titanium nitride film (TiN film).

Etching any of the films described herein may refer to removing at least some of the substances constituting the film.

### Etching composition

An etching composition may include an oxidizer, an ammonium salt, an aqueous solvent, and an accelerator.

The etching composition may be used in an etching process and/or a CMP process for a film to be etched, for example, the metal-containing film described herein.

According to an embodiment, the etching composition may not include at least one of a fluorine (F)-containing compound, a metal-containing compound, an inorganic anion-containing salt, and an inorganic acid (for example, a fluorine (F)-containing compound, a metal-containing compound, an inorganic anion-containing salt, and an inorganic acid).

The F-containing compound refers to any compound including F and capable of dissociating in an aqueous solvent, and an example thereof includes hydrogen fluoride (HF).

The metal-containing compound refers to any compound including a metal and capable of dissociating in an aqueous solvent. For example, the metal may be an alkali metal (for example, lithium (Li), sodium (Na), potassium (K), rubidium (Rb), cesium (Cs), etc.), an alkaline earth metal (for example, beryllium (Be), magnesium (Mg), calcium (Ca), strontium (Sr), barium (Ba), etc.), Zn, etc. Examples of the metal-containing compound include 5-methyltetrazole sodium, 5-methyltetrazole lithium, etc.

Examples of the inorganic anion-containing salt include ammonium fluoride (NH₄F), ammonium chloride (NH₄Cl), etc.

The inorganic acid is an acid produced by a chemical reaction of an inorganic compound, and examples thereof include hydrochloric acid, nitric acid, sulfuric acid, phosphoric acid, etc.

According to another embodiment, the etching composition may not include sulfuric acid, phosphate, and persulfate.

According to an embodiment, the etching composition may consist of (or include) an oxidizer, an ammonium salt, an aqueous solvent, and an accelerator.

According to another embodiment, the etching composition may consist of (or include) hydrogen peroxide, an ammonium salt, water, and an accelerator.

### Oxidizer

The oxidizer serves to etch the metal-containing film, and may include, for example, hydrogen peroxide.

The amount (weight) of the oxidizer may be, for example, about 1 wt% to about 50 wt%, about 5 wt% to about 30 wt%, about 10 wt% to about 25 wt%, or about 15 wt% to about 25 wt%, per 100 wt% of the etching composition.

### Ammonium salt

The ammonium salt serves to etch the metal-containing film, and may include ammonium cations (NH₄⁺ ions) and organic anions.

For example, the organic anions may include at least one of [(R₁₀)CO₂]⁻, [CO₃]²⁻, [NO₃]⁻, [(R₁₀)SO₄]⁻, [(R₁₀)SO₃]⁻, citrate ([C₆H₇O₇]⁻, [C₆H₆O₇]²⁻, or [C₆H₅O₇]³⁻), phosphate ([PO₄]³⁻), sulfite ([SO₂]²⁻), oxalate ([C₂O₄]²⁻), tartrate ([C₄H₄O_{6]}²⁻), glutamate ([C₅H₈NO₄]⁻), salicylate ([C₇H₅O₃]⁻), and tetrafluoroborate ([BF₄]⁻).

R₁₀ may be: hydrogen, deuterium, *-OH, *-SH, or *-NH₂; or a C₁-C₂₀ alkyl group, a C₂-C₂₀ alkenyl group, a C₁-C₂₀ alkoxy group, a C₆-C₂₀ aryl group (for example, a phenyl group), a C₂-C₂₀ heteroaryl group, a C₇-C₂₀ arylalkyl group, or a C₃-C₂₀ heteroarylalkyl group, each unsubstituted or substituted with deuterium, *-F, *-CI, *-Br, *-I, *-OH, *-SH, *-NH₂, *-C(=O)-OH, a C₁-C₂₀ alkyl group, a C₁-C₂₀ alkoxy group, or any combination thereof.

According to another embodiment, the organic anion may include at least one of acetate, bicarbonate, benzoate, carbonate, formate, nitrate, hydrogen sulfate, carbamate, trifluoroacetate, sulfamate, citrate, phosphate, sulfite, sulfobenzoate, oxalate, lactate, tartrate, dihydrogencitrate, glutamate, salicylate, bioxalate, octanoate, propionate, glycolate, tetrafluoroborate, and gluconate.

According to another embodiment, the organic anion of the ammonium salt may include 2 or more carbon atoms.

According to an embodiment, the ammonium salt may include at least one of ammonium acetate, ammonium bicarbonate, ammonium benzoate, ammonium carbonate, ammonium formate, ammonium nitrate, ammonium hydrogen sulfate, ammonium carbamate, ammonium trifluoroacetate, ammonium sulfamate, ammonium citrate dibasic, ammonium citrate tribasic, ammonium phosphate tribasic, ammonium sulfite, 2-sulfobenzoic acid ammonium salt, ammonium oxalate monohydrate, ammonium lactate, ammonium tartrate, ammonium dihydrogencitrate, L-glutamic acid monoammonium salt, ammonium salicylate, ammonium bioxalate monohydrate, ammonium octanoate, ammonium propionate, ammonium glycolate, ammonium tetrafluoroborate, and ammonium gluconate.

According to another embodiment, the ammonium salt may not include inorganic anions such as halogen anions (F⁻ anions, Cl⁻ anions, etc.). Therefore, the ammonium salts are clearly distinguishable from ammonium salts including only inorganic anions, such as ammonium chloride (NH₄Cl).

According to another embodiment, the ammonium salt may not include phosphate anions. For example, the ammonium salt may not be a monoammonium phosphate (NH⁴⁺) (H₂PO₄⁻).

According to another embodiment, the ammonium salt may not include sulfates and carbonates. For example, the ammonium salt may not be ammonium sulfate and ammonium carbonate.

The amount (weight) of the ammonium salt may be about 0.5 wt% to about 20 wt%, about 0.5 wt% to about 10 wt%, about 1 wt% to about 20 wt%, about 0.5 wt% to about 10 wt%, about 1 wt% to about 7 wt%, or about 1 wt% to about 5 wt%, per 100 wt% of the etching composition.

### Aqueous solvent

The aqueous solvent, which is evidently distinct from various organic solvents, may include, for example, water (for example, deionized water).

According to an embodiment, the aqueous solvent may be water.

According to another embodiment, the etching composition may not include an organic solvent.

### Accelerator

The accelerator may include a first accelerator and a second accelerator, wherein the first accelerator and the second accelerator may be different from each other.

Each of the first accelerator and second accelerator may include at least one of a group represented by Formula A below, a group represented by Formula B below, and a group represented by Formula C below: 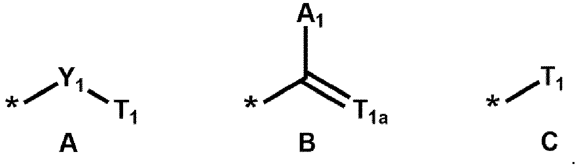 In Formula A to Formula C,
Y₁ may be C(Z₃)(Z₄), N(Z₃), C(=O), C(=S), S(=O)₂, or P(=O)(Z₃),
T₁ may be *-OH, *-SH, or *-NH₂,
T₁ₐ may be O or S,
Z₃ and Z₄ may each independently be:
   hydrogen, deuterium, *-F, *-Cl, *-Br, *-I, *-OH, *-SH, *-NH₂, *-C(=O)H, *-C(=S)H, *-C(=O)-OH, *-C(=S)-OH, *-C(=O)-SH, *-C(=S)-SH, *-C(=O)-(NH₂), *-C(=S)-(NH₂), *-NH-C(=O)-(NH₂), *-NH-C(=S)-(NH₂), *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH, *-C(=S)-C(=S)-SH, or *-C(=O)-ONH₄; or
   a C₁-C₂₀ alkyl group, a C₂-C₂₀ alkenyl group, a C₁-C₂₀ alkoxy group, a C₆-C₂₀ aryl group, a C₂-C₂₀ heteroaryl group, a C₇-C₂₀ arylalkyl group, or a C₃-C₂₀ heteroarylalkyl group, each unsubstituted or substituted with deuterium, *-F, *-CI, *-Br, *-I, *-OH, *-SH, *-NH₂, *-C(=O)H, *-C(=S)H, *-C(=O)-OH, *-C(=S)-OH, *-C(=O)-SH, *-C(=S)-SH, *-C(=O)-(NH₂), *-C(=S)-(NH₂), *-NH-C(=O)-(NH₂), *-NH-C(=S)-(NH₂), *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH, *-C(=S)-C(=S)-SH, *-C(=O)-ONH₄, or any combination thereof,
   A₁ may be:
      hydrogen or deuterium; or
      a C₁-C₂₀ alkyl group (for example, C₁-C₁₀ alkyl group), a C₂-C₂₀ alkenyl group (for example, a C₂-C₁₀ alkenyl group), a C₁-C₂₀ alkoxy group (for example, a C₁-C₁₀ alkoxy group), a C₆-C₂₀ aryl group (for example, a phenyl group or the like), a C₂-C₂₀ heteroaryl group (for example, a pyridinyl group), a C₇-C₂₀ arylalkyl group (for example, a methyl group substituted with a phenyl group), or a C₃-C₂₀ heteroarylalkyl group (for example, a methyl group substituted with a pyridinyl group), each unsubstituted or substituted with deuterium, *-F, *-CI, *-Br, *-I, a C₁-C₂₀ alkyl group, a C₁-C₂₀ alkoxy group, or any combination thereof, and
      * is a binding site with any atom of the first accelerator and any atom of the second accelerator.

Each of Formula A to Formula C may provide a reactive site (for example, T₁, T₁ₐ, etc.) capable of binding with a metal in a metal-containing film in contact with the etching composition.

The Y₁, T₁, T₁ₐ, Z₃, Z₄, and A₁ of Formula A to Formula C are respectively the same as those described in the present specification.

According to an embodiment, each of the first accelerator and the second accelerator may not be an amino acid.

According to another embodiment, at least one of the first accelerator and the second accelerator may include 2 or more groups represented by Formula A.

According to another embodiment,
i) each of the first accelerator and the second accelerator may be a first compound,
ii) one of the first accelerator and the second accelerator may be a first compound and the other may be a second compound, or
iii) each of the first accelerator and the second accelerator may be a second compound,

wherein the first compound may be a compound capable of forming a cyclometallated 5-membered ring or a cyclometallated 6-membered ring, which includes a metal or metal ion combined with at least one of O, S, and N, and
the second compound may be a compound that is incapable of forming the cyclometallated 5-membered ring and cyclometallated 6-membered ring.

According to another embodiment, at least one of the first accelerator and the second accelerator may be the first compound described herein.

For example, the first compound may be a compound capable of forming a cyclometallated 5-membered ring represented by Formula CM5 below or a cyclometallated 6-membered ring represented by Formula CM6 below: 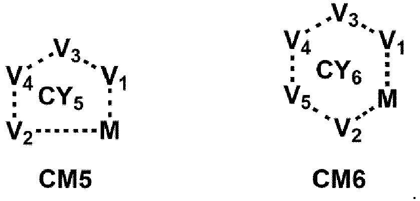 In Formula CM5 and Formula CM6,
M may be a metal or metal ion,
V₁ and V₂ may each independently be O, S, or N,
V₃, V₄, and V₅ may each independently be O, S, N, C, or P,
dashed lines are chemical bonds (for example, covalent bonds, coordinate bonds, single bonds, double bonds, etc.),
CY₅ represents a cyclometallated 5-membered ring, and
CY₆ represents a cyclometallated 6-membered ring.
M of Formula CM5 and Formula CM6 may be a metal or metal ion included in the metal-containing film in contact with the etching composition.

For example, M of Formula CM5 and Formula CM6 may be indium (In), titanium (Ti), aluminum (Al), lanthanum (La), scandium (Sc), gallium (Ga), zinc (Zn), hafnium (Hf), or an ion thereof.

According to another embodiment, CY₅ and CY₆ of Formula CM5 and Formula CM6 may have a resonance structure.

According to an embodiment, the first compound may be a compound represented by one of Formula 1-1 to Formula 1-6 and Formula 2-1 to Formula 2-8 below: 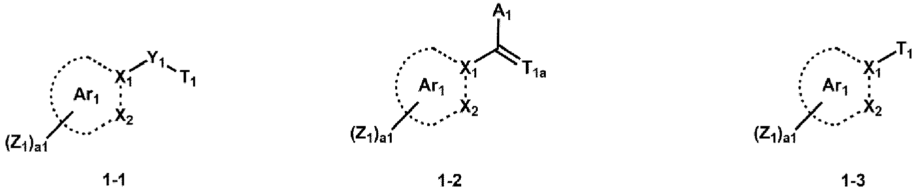 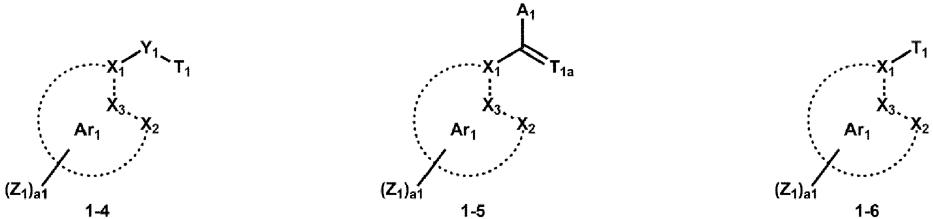 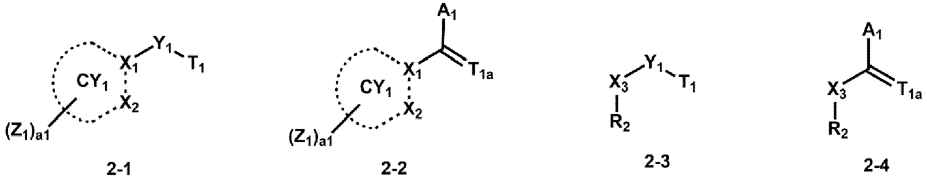 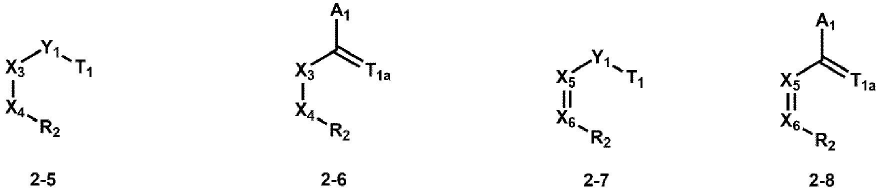
Ar₁ of Formula 1-1 to Formula 1-6 may be an unsaturated C₃-C₂₀ cyclic group,
X₁ and X₃ of Formula 1-1 to Formula 1-6 may each independently be C or N,
X₂ of Formula 1-1, Formula 1-2, and Formula 1-6 may be C(R₂), N(R₂), N(H), *-N=*', *=N-*', O, or S,
X₂ of Formula 1-3 may be C(R₂) or N(R₂),
X₂ of Formula 1-4 and Formula 1-5 may be N(H), *-N=*', *=N-*', O, or S,
X₁ and X₂ of Formula 1-1 to Formula 1-3 may be connected to each other by a single bond or a double bond,
X₁ and X₃ of Formula 1-4 to Formula 1-6 may be connected to each other by a single bond or a double bond,
X₂ and X₃ of Formula 1-4 to Formula 1-6 may be connected to each other by a single bond or a double bond,
CY₁ of the Formula 2-1 and Formula 2-2 may be a saturated C₃-C₈ cyclic group,
X₁ of Formula 2-1 and Formula 2-2 may be C or N,
X₂ of Formula 2-1 and Formula 2-2 may be C(R₂), N(R₂), O, S, or N(H),
X₁ and X₂ of Formula 2-1 and Formula 2-2 may be connected to each other by a single bond,
X₃ of Formula 2-3 to Formula 2-6 may be C(Z₁)(Z₂), N(Z₁), C(=O), or C(=S),
X₄ of Formula 2-5 and Formula 2-6 may be C(Z₁₁)(Z₁₂), N(Z₁₁), C(=O), or C(=S),
X₅ of Formula 2-7 and Formula 2-8 may be C(Z₁) or N,
X₆ of Formula 2-7 and Formula 2-8 may be C(Z₁₁) or N,
Y₁, T₁, and T₁ₐ of Formula 1-1 to Formula 1-6 and Formula 2-1 to Formula 2-8 are each the same as defined herein,
R₂ of Formula 2-3 to Formula 2-8 may be *-O(Z₅), *-S(Z₅), or *-N(Z₅)(Z₆),
Z₁ to Z₆, Z₁₁, and Z₁₂ of Formula 1-1 to Formula 1-6 and Formula 2-1 to Formula 2-8 may each independently be:
   hydrogen, deuterium, *-F, *-Cl, *-Br, *-I, *-OH, *-SH, *-NH₂, *-C(=O)H, *-C(=S)H, *-C(=O)-OH, *-C(=S)-OH, *-C(=O)-SH, *-C(=S)-SH, *-C(=O)-(NH₂), *-C(=S)-(NH₂), *-NH-C(=O)-(NH₂), *-NH-C(=S)-(NH₂), *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH, *-C(=S)-C(=S)-SH, or *-C(=O)-ONH₄; or
   a C₁-C₂₀ alkyl group (for example, a C₁-C₁₀ alkyl group), a C₂-C₂₀ alkenyl group (for example, a C₂-C₁₀ alkenyl group), a C₁-C₂₀ alkoxy group (for example, a C₁-C₁₀ alkoxy group), a C₆-C₂₀ aryl group (for example, a phenyl group or the like), a C₂-C₂₀ heteroaryl group (for example, a pyridinyl group), a C₇-C₂₀ arylalkyl group (for example, a methyl group substituted with a phenyl group), or a C₃-C₂₀ heteroarylalkyl group (for example, a methyl group substituted with a pyridinyl group), each unsubstituted or substituted with deuterium, *-F, *-CI, *-Br, *-I, *-OH, *-SH, *-NH₂, *-C(=O)H, *-C(=S)H, *-C(=O)-OH, *-C(=S)-OH, *-C(=O)-SH, *-C(=S)-SH, *-C(=O)-(NH₂), *-C(=S)-(NH₂), *-NH-C(=O)-(NH₂), *-NH-C(=S)-(NH₂), *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH, *-C(=S)-C(=S)-SH, *-C(=O)-ONH₄, or any combination thereof,
   a1 of Formula 1-1 to Formula1-6, Formula 2-1 and Formula 2-2 may be an integer from 0 to 5,
   A₁ of Formula 1-2, Formula 1-5, Formula 2-2, Formula 2-4, Formula 2-6, and Formula 2-8 is the same as defined herein, and
   each of * and *' is a binding site with a neighboring atom.

According to an embodiment, Ar₁ may be i) a 5-membered ring, ii) a 6-membered ring, iii) a condensed ring of 2 or more 5-membered rings condensed with each other, iv) a condensed ring of 2 or more 6-membered rings condensed with each other, or v) a condensed ring of 1 or more 5-membered rings and 1 or more 6-membered rings condensed with each other. For example, the 5-membered ring may be a furan group, a thiophene group, a pyrrole group, a cyclopentene group, an imidazole group, a pyrazole group, a triazole group, or a thiazole group, and the 6-membered ring may be a benzene group, a pyridine group, a pyrimidine group, a pyrazine group, a pyridazine group, a cyclohexane group, a cyclohexene group, a 4H-pyran-4-one group, or a pyridin-2(1H)-one group.

For example, Ar₁ may be a benzene group, a naphthalene group, a pyridine group, a pyrimidine group, a pyrazine group, a pyridazine group, an imidazole group, a pyrazole group, a triazole group, a 4H-pyran-4-one group, a carbazole group, a dibenzofuran group, a dibenzothiophene group, or a pyridin-2(1H)-one group.

CY₁ may be a 5-membered saturated cyclic group or a 6-membered saturated cyclic group.

For example, CY₁ may be a cyclopentane group, a cyclohexane group, a cycloheptane group, a pyrrolidine group, a piperidine group, an azepane group, a tetrahydrofuran group, a tetrahydrothiophene group, a tetrahydro-2H-pyran group, a tetrahydro-2H-thiopyran group, or a piperidin-2-one group.

Z₁ of Formula 1-1 to Formula 1-6 may be bonded to (or substituted for) any atom forming the backbone of Ar₁, including X₁ to X₃, and Z₁ of Formula 2-1 and Formula 2-2 may be bonded to (or substituted for) any atom forming the backbone of CY₁, including X₁ and X₂.

As used herein, Z₁ to Z₆, Z₁₁ and Z₁₂ may each independently be:
hydrogen, deuterium, *-F, *-Cl, *-Br, *-I, *-OH, *-SH, *-NH₂, *-C(=O)H, *-C(=S)H, *-C(=O)-OH, *-C(=S)-OH, *-C(=O)-SH, *-C(=S)-SH, *-C(=O)-(NH₂), *-C(=S)-(NH₂), *-NH-C(=O)-(NH₂), *-NH-C(=S)-(NH₂), *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH, *-C(=S)-C(=S)-SH, or *-C(=O)-ONH₄; or
a C₁-C₂₀ alkyl group or a C₇-C₂₀ arylalkyl group, each unsubstituted or substituted with deuterium, *-F, *-CI, *-Br, *-I, *-OH, *-SH, *-NH₂, *-C(=O)H, *-C(=S)H, *-C(=O)-OH, *-C(=S)-OH, *-C(=O)-SH, *-C(=S)-SH, *-C(=O)-(NH₂), *-C(=S)-(NH₂), *-NH-C(=O)-(NH₂), *-NH-C(=S)-(NH₂), *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH, *-C(=S)-C(=S)-SH, *-C(=O)-ONH₄, or any combination thereof.
a1 of Formula 1-1 to Formula1-6, Formula 2-1 and Formula 2-2 represents the number of Z₁, which may be an integer from 0 to 5. When a1 is 2 or greater, 2 or more of Z₁ may be identical to or different from each other.

According to an embodiment, T₁ and R₂ may be identical to each other.

According to another embodiment, T₁ and R₂ may be different from each other.

According to another embodiment, Y₁ of Formula 1-1 to Formula 1-6 and Formula 2-1 to Formula 2-8 may be C(Z₃)(Z₄), N(Z₃), C(=O), or C(=S).

According to another embodiment, in Formula 2-3 to Formula 2-8,
X₃ may be C(Z₁)(Z₂), C(=O), or C(=S),
X₄ may be C(Z₁₁)(Z₁₂), C(=O), or C(=S),
X₅ may be C(Z₁),
X₆ may be C(Z₁₁),
Y₁ may be C(Z₃)(Z₄), C(=O), or C(=S),
T₁ may be *-OH or *-SH,
R₂ may be *-O(Z₅) or *-S(Z₅), and
Z₁ to Z₆, Z₁₁, and Z₁₂ may each independently be:
   hydrogen, deuterium, *-F, *-CI, *-Br, *-I, *-OH, *-SH, *-C(=O)H, *-C(=S)H, *-C(=O)-OH, *-C(=S)-OH, *-C(=O)-SH, *-C(=S)-SH, *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH or *-C(=S)-C(=S)-SH; or
   a C₁-C₂₀ alkyl group, a C₂-C₂₀ alkenyl group, a C₁-C₂₀ alkoxy group, a C₆-C₂₀ aryl group, a C₂-C₂₀ heteroaryl group, a C₇-C₂₀ arylalkyl group, or a C₃-C₂₀ heteroarylalkyl group, each unsubstituted or substituted with deuterium, *-F, *-CI, *-Br, *-I, *-OH, *-SH, *-C(=O)H, *-C(=S)H, *-C(=O)-OH, *-C(=S)-OH, *-C(=O)-SH, *-C(=S)-SH, *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH, *-C(=S)-C(=S)-SH, or any combination thereof.

According to another embodiment, X₃ of Formula 2-3 and Formula 2-4 may be C(Z₁)(Z₂), wherein at least one of Z₁ and Z₂ may be C₁-C₂₀ alkyl group or a C₇-C₂₀ arylalkyl group, each unsubstituted or substituted with deuterium, *-F, *-CI, *-Br, *-I, *-OH, *-SH, *-NH₂, *-C(=O)H, *-C(=S)H, *-C(=O)-OH, *-C(=S)-OH, *-C(=O)-SH, *-C(=S)-SH, *-C(=O)-(NH₂), *-C(=S)-(NH₂), *-NH-C(=O)-(NH₂), *-NH-C(=S)-(NH₂), *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH, *-C(=S)-C(=S)-SH, *-C(=O)-ONH₄, or any combination thereof.

According to another embodiment, in Formula 2-5 and Formula 2-6, X₃ may be C(Z₁)(Z₂), X₄ may be C(Z₁₁)(Z₁₂), wherein at least one of Z₁, Z₂, Z₁₁, and Z₁₂ may be a C₁-C₂₀ alkyl group or a C₇-C₂₀ arylalkyl group, each unsubstituted or substituted with deuterium, *-F, *-Cl, *-Br, *-I, *-OH, *-SH, *-NH₂, *-C(=O)H, *-C(=S)H, *-C(=O)-OH, *-C(=S)-OH, *-C(=O)-SH, *-C(=S)-SH, *-C(=O)-(NH₂), *-C(=S)-(NH₂), *-NH-C(=O)-(NH₂), *-NH-C(=S)-(NH₂), *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH, *-C(=S)-C(=S)-SH, *-C(=O)-ONH₄, or any combination thereof.

According to another embodiment, the first compound may not include P.

According to another embodiment, the first compound may be one of Compound 1-E1 to Compound 1-E16 and Compound 2-E1 to Compound 2-E32 below:

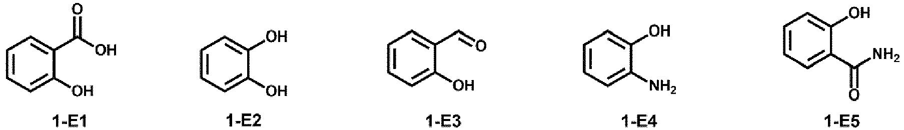

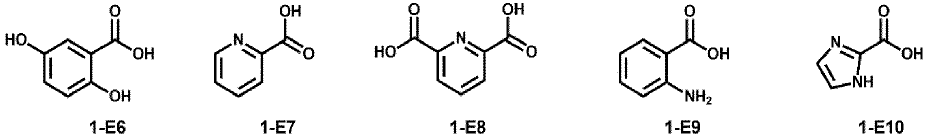

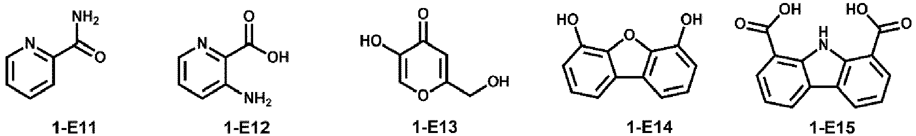

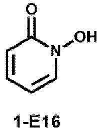

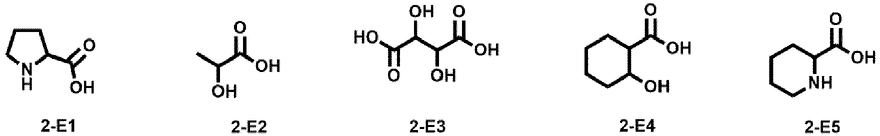

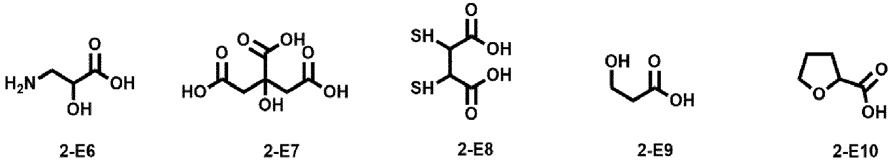

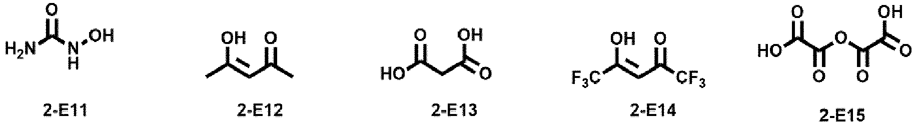

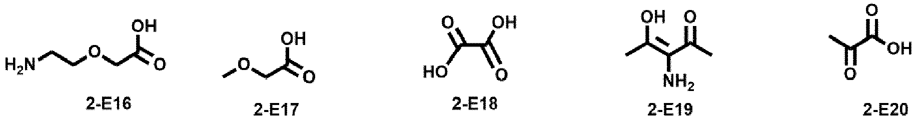

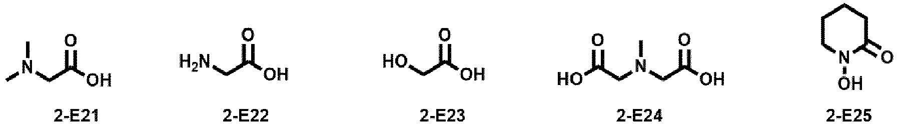

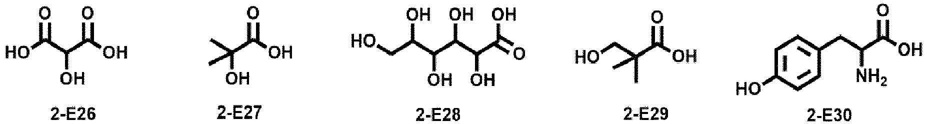

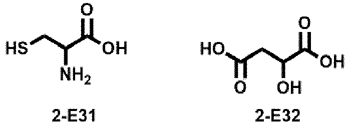

For example, each of Compound 1-E1, Compound 1-E2, Compound 1-E7, Compound 1-E14 and Compound 1-E15, upon contact with the metal-containing film, may form a cyclometallated 5-membered ring (see Compound 1-E2-M, Compound 1-E7-M, and Compound 1-E14-M) and a cyclometallated 6-membered ring (see Compound 1-E1-M and Compound 1-E15-M), which contain M which is a metal or metal ion included in the metal-containing film, as in Compound 1-E1-M, Compound 1-E2-M, Compound 1-E7-M, Compound 1-E14-M, and Compound 1-E15-M:

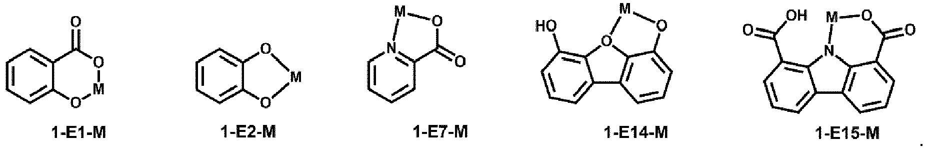

According to another embodiment, each of Compound 2-E1, Compound 2-E2, Compound 2-E3, Compound 2-E4, Compound 2-E5, Compound 2-E9, Compound 2-E10, Compound 2-E12, Compound 2-E18, and Compound 2-E23, upon contact with the metal-containing film, may form a cyclometallated 5-membered ring (see Compound 2-E1-M, Compound 2-E2-M, Compound 2-E3-M, Compound 2-E5-M, Compound 2-E10-M, Compound 2-E18-M, and Compound 2-E23-M) and a cyclometallated 6-membered ring (see Compound 2-E4-M, Compound 2-E9-M, and Compound 2-E12-M), which contain M which is a metal or metal ion included in the metal-containing film, as in Compound 2-E1-M, Compound 2-E2-M, Compound 2-E3-M, Compound 2-E4-M, Compound 2-E5-M, Compound 2-E9-M, Compound 2-E10-M, Compound 2-E12-M, Compound 2-E18-M, and Compound 2-E23-M:

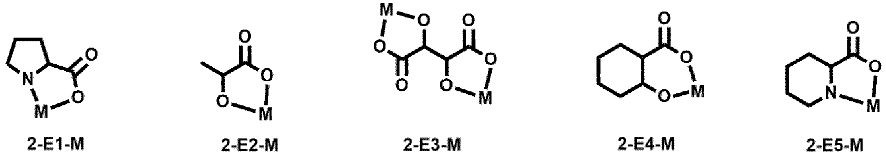

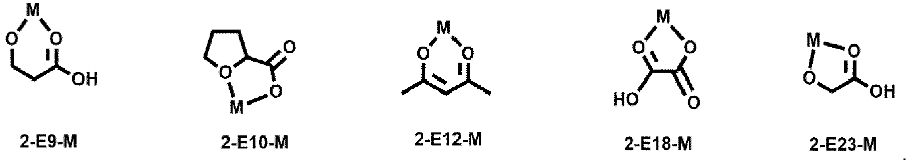

In Formula 1-1 to Formula 1-6, X₁ and X₂ may be connected to each other through a single bond or a double bond, X₁ and X₃ may be connected to each other through a single bond or a double bond, X₂ and X₃ may be connected to each other through a single bond or a double bond, and i) X₂ of Formula 1-1, Formula 1-2, and Formula 1-6 may be C(R₂), N(R₂), N(H), *-N=*', *=N-*', O, or S, ii) X₂ of Formula 1-3 may be C(R₂) or N(R₂), and iii) X₂ of Formula 1-4 and Formula 1-5 may be N(H), *-N=*', *=N-*', O, or S. Additionally, in Formula 1-1 to Formula 1-6, T₁ may be *-OH, *-SH, or *-NH₂, T₁ₐ may be O or S, and R₂ may be *-O(Z₅), *-S(Z₅), or *-N(Z₅)(Z₆). Accordingly the compound represented by Formula 1-1, the compound represented by Formula 1-2, the compound represented by Formula 1-3, the compound represented by Formula 1-4, the compound represented by Formula 1-5, and the compound represented by Formula 1-6, during the etching process and/or the CMP process, may be bonded with the metal (M) included in the metal-containing film, which is the film to be etched, through O, S and/or N, to form a "stable" cyclometallated 5-membered ring or cyclometallated 6-membered ring, and as a result, the etching rate and etching selectivity of the metal-containing film may be significantly improved.

According to another embodiment, in Formula 2-1 to Formula 2-8,
i) X₁ and X₂ of Formula 2-1 and Formula 2-2 may be connected to each other by a single bond,
ii) T₁ and R₂ of Formula 2-3 may be connected to each other with Y₁ and X₃ arranged therebetween (in other words, R₂ may be substituted into the α-carbon of atoms arranged between X₃ and T₁ and directly bonded to X₃ and T₁),
iii) T₁ₐ and R₂ of Formula 2-4 may be connected to each other with a carbon to which A₁ is directly bonded and X₃ arranged therebetween (in other words, R₂ may be substituted into the α-carbon of a carbon atom to which A₁ is directly bonded),
iv) T₁ and R₂ of Formula 2-5 may be connected to each other with Y₁, X₃, and X₄ arranged therebetween (in other words, R₂ may be substituted into the β-carbon of atoms arranged between X₃ and T₁ and directly bonded to X₃ and T₁),
v) T₁ₐ and R₂ of Formula 2-6 may be connected to each other with a carbon to which A₁ is directly bonded, X₃, and X₄ arranged therebetween (in other words, R₂ may be substituted into the β-carbon of carbon atoms to which A₁ is directly bonded),
vi) T₁ and R₂ of Formula 2-7 may be connected to each other with Y₁, X₅, and X₆ arranged therebetween (in other words, R₂ may be substituted into the β-carbon of atoms arranged between X₅ and T₁ and directly bonded to X₅ and T₁), and
vii) T₁ₐ and R₂ of Formula 2-8 may be connected to each other with a carbon to which A₁ is directly bonded, X₅, and X₆ arranged therebetween (in other words, R₂ may be substituted into the β-carbon of carbon atoms to which A₁ is directly bonded).

Additionally, in Formula 2-1 to Formula 2-8, X₂ may be C(R₂), N(R₂), O, S, or N(H), T₁ may be *-OH, *-SH, or *-NH₂, T₁ₐ is O or S, and R₂ may be *-O(Z₅), *-S(Z₅), or *-N(Z₅)(Z₆).

Accordingly, the compound represented by Formula 2-1, the compound represented by Formula 2-2, the compound represented by Formula 2-3, the compound represented by Formula 2-4, the compound represented by Formula 2-5, the compound represented by Formula 2-6, the compound represented by Formula 2-7, and the compound represented by Formula 2-8, during the etching process and/or the CMP process, may bond with the metal (M) included in the metal-containing film, which is the film to be etched, through O, S and/or N, to form a "stable" cyclometallated 5-membered ring or cyclometallated 6-membered ring, and as a result, the etching rate and the etching selectivity of the metal-containing film may be significantly improved.

According to another embodiment, the second compound may be a compound represented by one of Formula 3-1 to Formula 3-5:

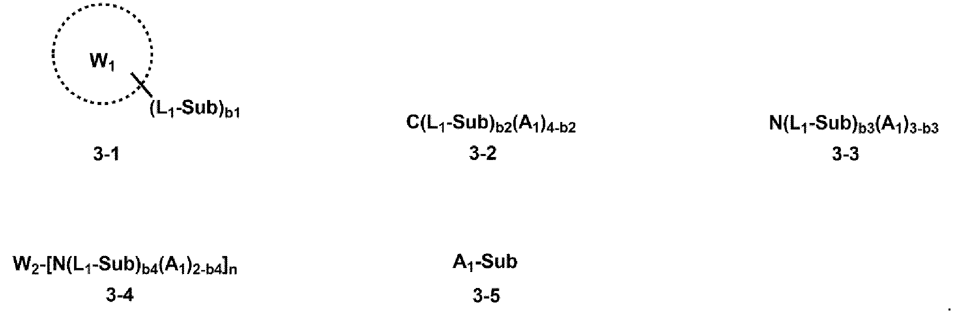

In Formula 3-1 to Formula 3-5,
W₁ may be a C₃-C₂₀ cyclic group (for example, 3 to 10 carbon atoms) that is unsubstituted or substituted with at least one Z₁,
W₂ may be a C₁-C₂₀ aliphatic hydrocarbon group (for example, 1 to 10 carbon atoms) that is unsubstituted or substituted with at least one Z₁,
L₁ may be: a single bond; or a C₁-C₂₀ alkylene group or a C₂-C₂₀ alkenylene group, each unsubstituted or substituted with at least one Z₁,
Sub may be a group represented by Formula A, a group represented by Formula B, or a group represented by Formula C,
A₁ is the same as defined herein,
b1 may be an integer from 1 to 10,
b2 may be an integer from 1 to 4,
b3 may be an integer from 1 to 3,
b4 may be 1 or 2,
n may be an integer from 1 to 5,
Z₁ may be:
   hydrogen, deuterium, *-F, *-CI, *-Br, *-I, *-OH, *-SH, *-NH₂, *-C(=O)H, *-C(=S)H, *-C(=O)-OH, *-C(=S)-OH, *-C(=O)-SH, *-C(=S)-SH, *-C(=O)-(NH₂), *-C(=S)-(NH₂), *-NH-C(=O)-(NH₂), *-NH-C(=S)-(NH₂), *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH, *-C(=S)-C(=S)-SH, or *-C(=O)-ONH₄; or
   a C₁-C₂₀ alkyl group (for example, a C₁-C₁₀ alkyl group), a C₂-C₂₀ alkenyl group (for example, a C₂-C₁₀ alkenyl group), a C₁-C₂₀ alkoxy group (for example, a C₁-C₁₀ alkoxy group), a C₆-C₂₀ aryl group (for example, a phenyl group or the like), a C₂-C₂₀ heteroaryl group (for example, a pyridinyl group), a C₇-C₂₀ arylalkyl group (for example, a methyl group substituted with a phenyl group), or a C₃-C₂₀ heteroarylalkyl group (for example, a methyl group substituted with a pyridinyl group), each unsubstituted or substituted with deuterium, *-F, *-Cl, *-Br, *-I, *-OH, *-SH, *-NH₂, *-C(=O)H, *-C(=S)H, *-C(=O)-OH, *-C(=S)-OH, *-C(=O)-SH, *-C(=S)-SH, *-C(=O)-(NH₂), *-C(=S)-(NH₂), *-NH-C(=O)-(NH₂), *-NH-C(=S)-(NH₂), *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH, *-C(=S)-C(=S)-SH, *-C(=O)-ONH₄, or any combination thereof, and
* is a binding site with a neighboring atom.

The Z₁ is the same as those described in the present specification.

According to an embodiment, W₁ may be a benzene group, a cyclohexane group, a pyridine group, or a pyrrolidine group.

According to another embodiment, Sub may be a group represented by formula A, wherein Y₁ of Formula A may be C(Z₃)(Z₄), N(Z₃), C(=O), or C(=S).

In Formula 3-1 to Formula 3-5, a plurality of groups denoted by *-L₁-Sub may be identical to or different from each other, a plurality of A₁ may be identical to as or different from each other, and a plurality of groups denoted by *-N(L₁-Sub)_{b4}(A₁)_{2-b4} may be identical to or different from each other.

According to another embodiment, the second compound may not include P.

According to another embodiment, the second compound may be one of Compound 3-E1 to Compound 3-E14 below:

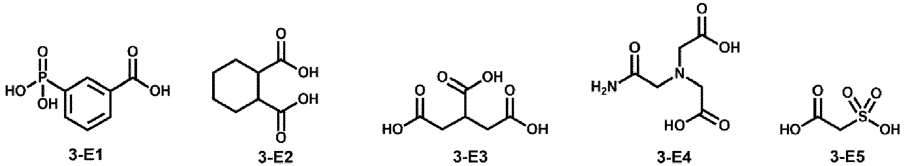

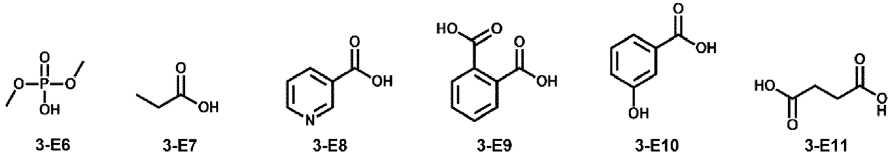

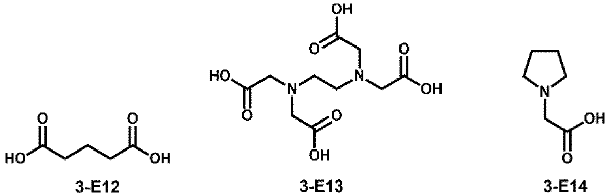

For example, each of Compound 3-E2, Compound 3-E3, and Compound 3-E9 may, upon contact with a metal-containing film, form a cyclometallated 7-membered ring including M which is a metal or metal ion included in the metal-containing film, as in Compound 3-E2-M, Compound 3-E3-M, and Compound 3-E9-M below:

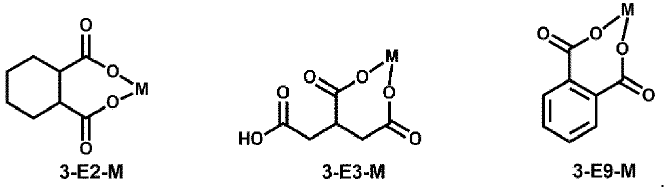

The accelerator, including a first accelerator and a second accelerator that are different from each other as described above, may have an easily controlled etching performance for various films, thereby having a high etching rate for the film to be etched and an excellent etching selectivity for adjacent films. Therefore, an effective etching process and/or a CMP process may be performed on the film to be etched by utilizing the etching composition, and a semiconductor device fabricated using the metal-containing film etching process using the etching composition may have excellent performance.

The accelerator may further include, in addition to the first accelerator and the second accelerator, another accelerator. The other accelerator may be two or more different accelerators, and may be selected from the first compound and the second compound described herein, or may be selected from any accelerator.

According to another embodiment, the weight ratio of the first accelerator to the second accelerator may be selected from within the range of about 1:99 to about 99:1, about 10:90 to about 90:10, about 20:80 to about 80:20, about 30:70 to about 70:30, depending on the purpose of use of the etching composition, the film to be etched, etc.

The amount (weight) of the accelerator may be selected from within the range of about 0.001 wt% to about 20 wt%, about 0.001 wt% to about 15 wt%, about 0.001 wt% to about 10 wt%, about 0.001 wt% to about 7 wt%, about 0.001 wt% to about 5 wt%, about 0.001 wt% to about 4 wt%, about 0.001 wt% to about 3 wt%, about 0.001 wt% to about 2 wt%, about 0.001 wt% to about 1 wt%, about 0.005 wt% to about 20 wt%, about 0.005 wt% to about 15 wt%, about 0.005 wt% to about 10 wt%, about 0.005 wt% to about 10 wt%, about 0.005 wt% to about 7 wt%, about 0.005 wt% to about 5 wt%, about 0.005 wt% to about 4 wt%, about 0.005 wt% to about 3 wt%, about 0.005 wt% to about 2 wt%, about 0.005 wt% to about 1 wt%, about 0.01 wt% to about 20 wt%, about 0.01 wt% to about 15 wt%, about 0.01 wt% to about 10 wt%, about 0.01 wt% to about 7 wt%, about 0.01 wt% to about 5 wt%, about 0.01 wt% to about 4 wt%, about 0.01 wt% to about 3 wt%, about 0.01 wt% to about 2 wt%, or about 0.01 wt% to about 1 wt%, per 100 wt% of the etching composition. By satisfying the amount of the accelerator in the ranges as described above, the stability of the etching composition may be secured.

The amount (weight) of each of the first accelerator and the second accelerator may be, for example, about 0.0005 wt% to about 15 wt%, about 0.0005 wt% to about 10 wt%, about 0.0005 wt% to about 7 wt%, about 0.0005 wt% to about 5 wt%, about 0.0005 wt% to about 4 wt%, about 0.0005 wt% to about 3 wt%, about 0.0005 wt% to about 2 wt%, about 0.0005 wt% to about 1 wt%, about 0.0005 wt% to about 0.5 wt%, about 0.001 wt% to about 15 wt%, about 0.001 wt% to about 10 wt%, about 0.001 wt% to about 7 wt%, about 0.001 wt% to about 5 wt%, about 0.001 wt% to about 4 wt%, about 0.001 wt% to about 3 wt%, about 0.001 wt% to about 2 wt%, about 0.001 wt% to about 1 wt%, about 0.001 wt% to about 0.5 wt%, about 0.005 wt% to about 15 wt%, about 0.005 wt% to about 10 wt%, about 0.005 wt% to about 7 wt%, about 0.005 wt% to about 5 wt%, about 0.005 wt% to about 4 wt%, about 0.005 wt% to about 3 wt%, about 0.005 wt% to about 2 wt%, about 0.005 wt% to about 1 wt%, about 0.005 wt% to about 0.5 wt%, about 0.01 wt% to about 15 wt%, about 0.01 wt% to about 10 wt%, about 0.01 wt% to about 7 wt%, about 0.01 wt% to about 5 wt%, about 0.01 wt% to about 4 wt%, about 0.01 wt% to about 3 wt%, about 0.01 wt% to about 2 wt%, about 0.01 wt% to about 1 wt%, or about 0.01 wt% to about 0.5 wt%, per 100 wt% of the etching composition.

The etching composition including the oxidizer, ammonium salt, etc. as described above may have a pH of about 3.0 to about 8.3, about 3.0 to about 8.0, about 3.0 to about 7.5, about 3.0 to about 7.0, about 3.0 to about 6.5, about 3.0 to about 6.0, about 3.0 to about 5.8, about 3.0 to about 5.6, about 3.0 to about 5.4, about 3.5 to about 6.0, about 3.5 to about 5.8, about 3.5 to about 5.6, about 3.5 to about 5.4, about 4.0 to about 6.0, about 4.0 to about 5.8, about 4.0 to about 5.6, or about 4.0 to about 5.4. By having the etching composition have a pH within the ranges mentioned above, chelation between the accelerator and the metal as described above may be effectively achieved.

According to an embodiment, the etching composition may be used in a metal-containing film etching process and/or a CMP process. A description of the metal-containing film is the same as those described in the present specification.

### Method of etching metal-containing film and method of manufacturing semiconductor device

The etching composition as described above may be utilized to effectively etch a metal-containing film.

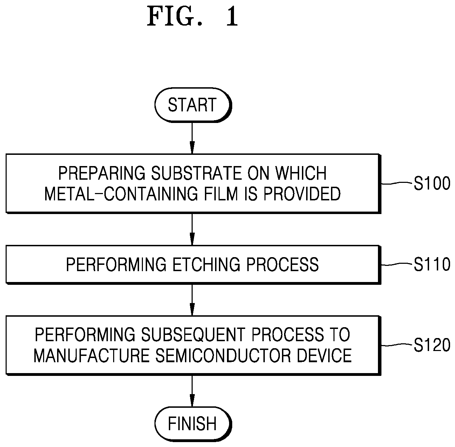

Referring to FIG. 1, an embodiment of the method of etching a metal-containing film may include: preparing a substrate on which a metal-containing film is provided (S100); and performing an etching process using an etching composition as described herein on the metal-containing film to remove at least a portion of the metal-containing film (S110).

The metal-containing film is the same as those described in the present specification.

For example, the metal-containing film may include indium (In), titanium (Ti), aluminum (Al), lanthanum (La), scandium (Sc), gallium (Ga), zinc (Zn), hafnium (Hf), or any combination thereof.

According to another embodiment, the metal-containing film may include a metal nitride, a metal oxide, a metal oxynitride, or a combination thereof.

When at least one of the first accelerator and the second accelerator included in the accelerator of the etching composition is the first compound described herein, the first compound may be a compound capable of forming a cyclometallated 5-membered ring or cyclometallated 6-membered ring, including a metal or metal ion combined with at least one of O, S, and N, and accordingly, the etching rate and etching selectivity of the metal-containing film may be significantly improved.

By using the metal-containing film etching process using the etching composition as described above, semiconductor devices with excellent performance may be manufactured.

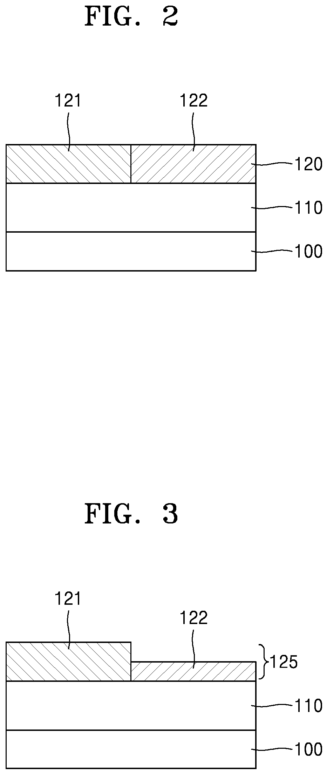

FIG. 2 and FIG. 3 are diagrams illustrating an embodiment of a method of etching a metal-containing film.

Referring to FIG. 2, a substrate 100 on which a metal-containing film 120 is provided is prepared. An intermediate layer 110 may be arranged between the substrate 100 and the metal-containing film 120. Although not shown in FIG. 2, circuitry elements (for example, transistor gates, metal lines), impurity regions, and semiconductor layers may be arranged within the substrate 100, on top of the substrate 100, and/or between the substrate 100 and the intermediate layer 110. According to an embodiment, the metal-containing film 120 may be arranged directly on the substrate 100, and the intermediate layer 110 may be omitted.

The metal-containing film 120 may include a first region 121 and a second region 122. A second etching rate at which the etching composition etches the second region 122 may be greater than a first etching rate at which the etching composition etches the first region 121.

Referring to FIG. 3, the etching composition may be used for etching the metal-containing film 120 to etch at least a portion of the first region 121 and at least a portion of the second region 122, respectively, to form a pattern of the metal-containing film 125. The etching process may be performed by contacting at least a portion of the first region 121 and at least a portion of the second region 122 with the etching composition.

The etching composition may etch at least a portion of the first region 121 and at least a portion of the second region 122, respectively. In FIG. 3, the pattern of the metal-containing film 125 formed after etching includes at least some of the second region 122, but various variations are possible, such as the etching process being performed so that the second region 122 of the pattern of the metal-containing film 125 is completely removed, if necessary.

According to another embodiment, the first region 121 may include at least one of a metal oxide (for example, aluminum oxide) and silicon oxide.

According to another embodiment, the second region 122 may include titanium nitride.

According to another embodiment, the second region 122 may include i) titanium nitride, ii) titanium nitride further including indium, aluminum, lanthanum, scandium, gallium, zinc, hafnium, or any combination thereof, or iii) a combination thereof.

According to another embodiment, each of the first region 121 and the second region 122 may include i) titanium nitride, ii) titanium nitride further including indium, aluminum, lanthanum, scandium, gallium, zinc, hafnium, or any combination thereof, or iii) a combination thereof.

According to another embodiment, the first region 121 may include aluminum and the second region 122 may not include aluminum.

According to another embodiment, the first region 121 may include titanium nitride (for example, titanium/aluminum nitride or TiAIN) further including aluminum, and the second region 122 may include titanium nitride (TiN).

According to another embodiment, the first region 121 may be a titanium nitride film further including aluminum (for example, a titanium/aluminum nitride film or TiAIN film), and the second region 122 may be a titanium nitride film (TiN film).

According to another embodiment, the etching rate ratio of the second region 122 to the first region 121 of the etching composition may be about 5 to about 30, about 5 to about 20, about 5 to about 15, or about 6.45 to about 12.72. The etching rate ratio of the second region 122 to the first region 121 may be obtained by dividing the second etching rate at which the etching composition etches the second region 122 by the first etching rate at which the etching composition etches the first region 121. If the etching rate ratio of the second region 122 to the first region 121 of the etching composition satisfies the ranges as described above, the efficiency and productivity of the etching process may be improved.

According to another embodiment, the first region 121 includes a titanium nitride film further including aluminum (for example, a titanium/aluminum nitride film or TiAIN film), the second region 122 includes a titanium nitride film (TiN film), and the etching rate ratio of the second region 122 to the first region 121 of the etching composition (hereinafter referred to as "R(TiN/TiAIN)") may be about 5 to about 30, about 5 to about 20, about 5 to about 15, or about 6.45 to about 12.72. R(TiN/TiAIN) may be obtained by dividing the rate at which the etching composition etches the second region 122 including a titanium nitride film (TiN film) by the rate at which the etching composition etches the first region 121 including a titanium nitride film further including aluminum (for example, a titanium/aluminum nitride film or TiAIN film).

Referring to FIG. 1, a method of manufacturing a semiconductor device according to an embodiment may include: preparing a substrate on which a metal-containing film is provided (S100); performing an etching process using the etching composition on the metal-containing film to remove at least a portion of the metal-containing film (S110); and performing a subsequent process to manufacture a semiconductor device (S120).

Example 1 to Example 3 and Comparative Example 1 to Comparative Example 3

Etching compositions of each of Example 1 to Example 3 and Comparative Example 1 to Comparative Example 3 were prepared by mixing the substances listed in Table 1 below in the amounts listed in Table 1. The remaining portion of each etching composition is water (deionized water).

**[Table 1]**

| | Oxidizer (Hydrogen peroxide) | Ammonium salts | | Accelerators | | | |
|---|---|---|---|---|---|---|---|
| | | | | First accelerator | | Second accelerator | |
| | Content (wt%) | Substance | Content (wt%) | Substa nce | Content (wt%) | Substa nce | Content (wt%) |
| Example 1 | 20 | Ammonium acetate | 3 | 2-E13 | 0.05 | 3-E11 | 0.35 |
| Example 2 | 20 | Ammonium acetate | 3 | 2-E13 | 0.05 | 3-E12 | 0.35 |
| Example 3 | 20 | Ammonium acetate | 3 | 2-E13 | 0.01 | 3-E12 | 0.39 |
| Comparative Example 1 | 20 | Ammonium Acetate | 3 | 2-E13 | 0.4 | - | - |
| Comparative Example 2 | 20 | Ammonium acetate | 3 | 3-E 11 | 0.4 | - | - |
| Comparative Example 3 | 20 | Ammonium Acetate | 3 | 3-E 12 | 0.4 | - | - |

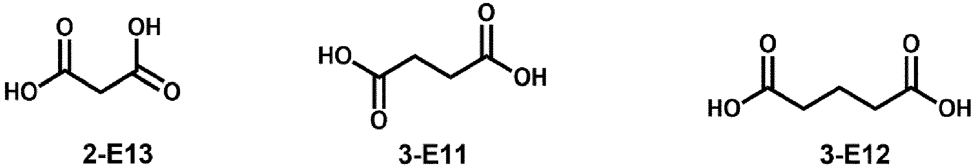

### Evaluation Example 1

The etching composition of Example 1 was placed in a beaker and heated to 70 °C, and each of the films to be etched, i.e., a titanium nitride film (TiN film) and a titanium/aluminum nitride film (TiAIN film) subjected to a plasma etching treatment were immersed in the etching composition of Example 1 for 5 minutes, and then the thickness of each of the films to be etched was measured using an ellipsometer (M-2000, J.A. Woolam). Then, the etching rate for each of the films to be etched was evaluated, and the results are summarized in Table 2.

Subsequently, R(TiN/TiAIN) was obtained by dividing the rate at which the etching composition etched the titanium nitride film by the rate at which the etching composition etched the titanium/aluminum nitride film, and the results are summarized in Table 2.

The tests were repeated using the etching compositions of Example 2 to Example 3 and/or Comparative Example 1 to Comparative Example 3, and the results are summarized in Table 2.

**[Table 2]**

| | Etching rate of film (Å/min) | | R(TiN / TiAlN) |
|---|---|---|---|
| | Titanium nitride film | Titanium/aluminum nitride film | |
| Example 1 | 268 | 36 | 7.44 |
| Example 2 | 271 | 42 | 6.45 |
| Example 3 | 280 | 22 | 12.72 |
| Comparative Example 1 | 234 | 109 | 2.15 |
| Comparative Example 2 | 298 | 0 | - |
| Comparative Example 3 | 317 | 0 | - |

From Table 2, it may be seen that the etching compositions of Example 1 to Example 3 and Comparative Example 1 were able to etch both titanium nitride and titanium/aluminum nitride films, whereas the etching compositions of Comparative Example 2 and Comparative Example 3 were unable to etch the titanium/aluminum nitride film. Therefore, the etching compositions of Comparative Example 2 and Comparative Example 3 cannot be used in a process that requires etching a titanium/aluminum nitride film.

On the other hand, from Table 2, the R(TiN/TiAIN) of the etching compositions of Example 1 to Example 3 satisfies a range of 5 to 30, whereas the R(TiN/TiAIN) of the etching composition of Comparative Example 1 is 2.15, and thus it may be seen that the etching compositions of Example 1 to Example 3 have excellent etching selectivity compared to the etching composition of Comparative Example 1, which may improve the efficiency and productivity of the etching process.

According to the one or more embodiments, since an etching composition has excellent etching selectivity for the metal-containing film, which is the film to be etched, and may increase the productivity and efficiency of an etching process, an effective etching process and/or CMP process for the film to be etched may be performed by utilizing the etching composition. Therefore, a semiconductor device manufactured using a metal-containing film etching process utilizing the above etching composition may have excellent performance.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of inventive concepts as defined by the following claims.

## Claims

1. An etching composition comprising:
an oxidizer; an ammonium salt; an aqueous solvent; and an accelerator, wherein
the ammonium salt comprises an ammonium cation and an organic anion,
the accelerator comprises a first accelerator and a second accelerator,
the first accelerator and the second accelerator are different from each other, and
each of the first accelerator and the second accelerator comprises at least one of a group represented by Formula A below, a group represented by Formula B below, and a group represented by Formula C below, 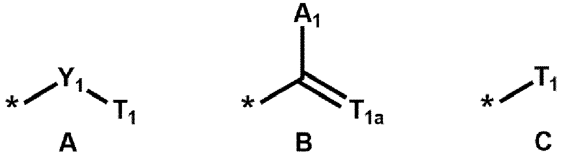 wherein, in Formula A to Formula C,
Y₁ is C(Z₃)(Z₄), N(Z₃), C(=O), C(=S), S(=O)₂, or P(=O)(Z₃),
T₁ is *-OH, *-SH, or *-NH₂,
T₁ₐ is O or S,
Z₃ and Z₄ are each independently
hydrogen, deuterium, *-F, *-CI, *-Br, *-I, *-OH, *-SH, *-NH₂, *-C(=O)H, *-C(=S)H, *-C(=O)-OH, *-C(=S)-OH, *-C(=O)-SH, *-C(=S)-SH, *-C(=O)-(NH₂), *-C(=S)-(NH₂), *-NH-C(=O)-(NH₂), *-NH-C(=S)-(NH₂), *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH, *-C(=S)-C(=S)-SH, or *-C(=O)-ONH₄, or
a C₁-C₂₀ alkyl group, a C₂-C₂₀ alkenyl group, a C₁-C₂₀ alkoxy group, a C₆-C₂₀ aryl group, a C₂-C₂₀ heteroaryl group, a C₇-C₂₀ arylalkyl group, or a C₃-C₂₀ heteroarylalkyl group, each unsubstituted or substituted with deuterium, *-F, *-CI, *-Br, *-I, *-OH, *-SH, *-NH₂, *-C(=O)H, *-C(=S)H, *-C(=O)-OH, *-C(=S)-OH, *-C(=O)-SH, *-C(=S)-SH, *-C(=O)-(NH₂), *-C(=S)-(NH₂), *-NH-C(=O)-(NH₂), *-NH-C(=S)-(NH₂), *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH, *-C(=S)-C(=S)-SH, *-C(=O)-ONH₄, or any combination thereof,
A₁ is
hydrogen or deuterium, or
a C₁-C₂₀ alkyl group, a C₂-C₂₀ alkenyl group, a C₁-C₂₀ alkoxy group, a C₆-C₂₀ aryl group, a C₂-C₂₀ heteroaryl group, a C₇-C₂₀ arylalkyl group, or a C₃-C₂₀ heteroarylalkyl group, each unsubstituted or substituted with deuterium, *-F, *-CI, *-Br, *-I, a C₁-C₂₀ alkyl group, a C₁-C₂₀ alkoxy group, or any combination thereof, and
* is a binding site to any atom of the first accelerator and any atom of the second accelerator.

2. The etching composition of claim 1, wherein
i) the first accelerator and the second accelerator each are a first compound,
ii) one of the first accelerator and the second accelerator is the first compound and the other of the first accelerator and the second accelerator is a second compound, or
iii) the first accelerator and the second accelerator each are the second compound,
wherein, the first compound is a compound capable of forming a cyclometallated 5-membered ring or a cyclometallated 6-membered ring, which comprises a metal or metal ion combined with at least one of O, S, and N, and
the second compound is a compound incapable of forming the cyclometallated 5-membered ring and the cyclometallated 6-membered ring.

3. The etching composition of claim 2, wherein
the first compound is a compound capable of forming a cyclometallated 5-membered ring represented by Formula CM5 below or a cyclometallated 6-membered ring represented by Formula CM6 below: 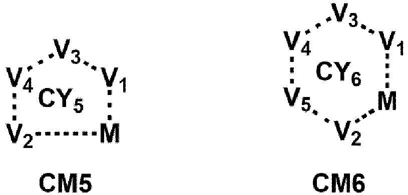 wherein, in Formula CM5 and Formula CM6,
M is a metal or metal ion,
V₁ and V₂ are each independently O, S, or N,
V₃, V₄, and V₅ are each independently O, S, N, C, or P,
dashed lines are chemical bonds,
CY₅ represents a cyclometallated 5-membered ring, and
CY₆ represents a cyclometallated 6-membered ring.

4. The etching composition of claims 2 or 3, wherein the first compound is a compound represented by one of Formula 1-1 to Formula 1-6 and Formula 2-1 to Formula 2-8 below: 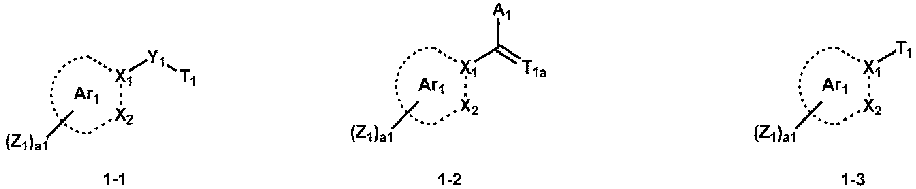 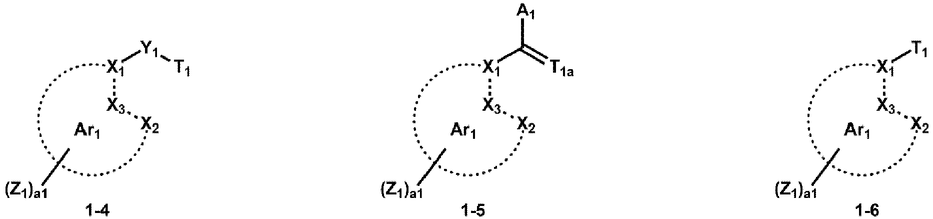 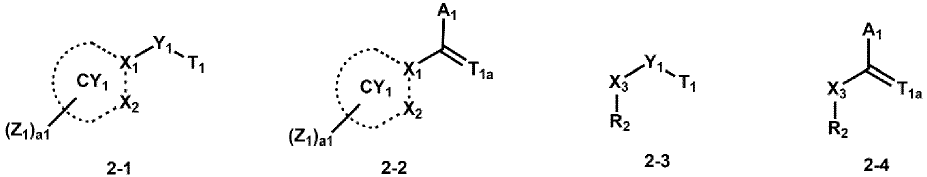 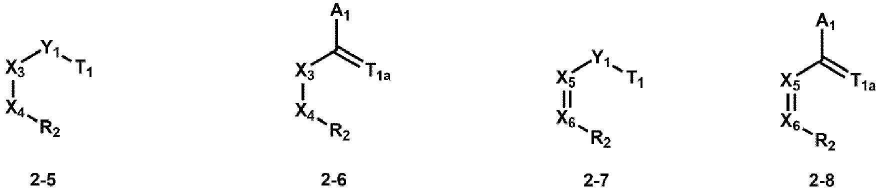 wherein Ar₁ of Formula 1-1 to Formula 1-6 is an unsaturated cyclic group having 3 to 20 carbon atoms,
X₁ and X₃ of Formula 1-1 to Formula 1-6 are each independently C or N,
X₂ of Formula 1-1, Formula 1-2, and Formula 1-6 is C(R₂), N(R₂), N(H), *-N=*', *=N-*', O, or S,
X₂ of Formula 1-3 is C(R₂) or N(R₂),
X₂ of Formula 1-4 and Formula 1-5 is N(H), *-N=*', *=N-*', O, or S,
X₁ and X₂ of Formula 1-1 to Formula 1-3 are connected to each other by a single bond or a double bond,
X₁ and X₃ of Formula 1-4 to Formula 1-6 are connected to each other by a single bond or a double bond,
X₂ and X₃ of Formula 1-4 to Formula 1-6 are connected to each other by a single bond or a double bond,
CY₁ of Formula 2-1 and Formula 2-2 is a saturated cyclic group having 3 to 8 carbon atoms,
X₁ of Formula 2-1 and Formula 2-2 is C or N,
X₂ of Formula 2-1 and Formula 2-2 is C(R₂), N(R₂), O, S, or N(H),
X₁ and X₂ of Formula 2-1 and Formula 2-2 are connected to each other by a single bond,
X₃ of Formula 2-3 to Formula 2-6 is C(Z₁)(Z₂), N(Z₁), C(=O), or C(=S),
X₄ of Formula 2-5 and Formula 2-6 is C(Z₁₁)(Z₁₂), N(Z₁₁), C(=O), or C(=S),
X₅ of Formula 2-7 and Formula 2-8 is C(Z₁) or N,
X₆ of Formula 2-7 and Formula 2-8 is C(Z₁₁) or N,
Y₁, T₁, and T₁ₐ of Formula 1-1 to Formula 1-6 and Formula 2-1 to Formula 2-8 are each the same as defined in claim 1,
R₂ of Formula 2-3 to Formula 2-8 is *-O(Z₅), *-S(Z₅), or *-N(Z₅)(Z₆),
Z₁ to Z₆, Z₁₁, and Z₁₂ of Formula 1-1 to Formula 1-6 and Formula 2-1 to Formula 2-8 are each independently:
hydrogen, deuterium, *-F, *-Cl, *-Br, *-I, *-OH, *-SH, *-NH₂, *-C(=O)H, *-C(=S)H, *-C(=O)-OH, *-C(=S)-OH, *-C(=O)-SH, *-C(=S)-SH, *-C(=O)-(NH₂), *-C(=S)-(NH₂), *-NH-C(=O)-(NH₂), *-NH-C(=S)-(NH₂), *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH, *-C(=S)-C(=S)-SH, or *-C(=O)-ONH₄; or
a C₁-C₂₀ alkyl group, a C₂-C₂₀ alkenyl group, a C₁-C₂₀ alkoxy group, a C₆-C₂₀ aryl group, a C₂-C₂₀ heteroaryl group, a C₇-C₂₀ arylalkyl group, or a C₃-C₂₀ heteroarylalkyl group, each unsubstituted or substituted with deuterium, *-F, *-CI, *-Br, *-I, *-OH, *-SH, *-NH₂, *-C(=O)H, *-C(=S)H, *-C(=O)-OH, *-C(=S)-OH, *-C(=O)-SH, *-C(=S)-SH, *-C(=O)-(NH₂), *-C(=S)-(NH₂), *-NH-C(=O)-(NH₂), *-NH-C(=S)-(NH₂), *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH, *-C(=S)-C(=S)-SH, *-C(=O)-ONH₄, or any combination thereof,
a1 of Formula 1-1 to Formula 1-6, 2-1, and 2-2 is an integer from 0 to 5,
A₁ of Formula 1-2, Formula 1-5, Formula 2-2, Formula 2-4, Formula 2-6, and Formula 2-8 is the same as defined in claim 1, and
each of * and *' is a binding site with a neighboring atom.

5. The etching composition of claim 4, wherein
Ar₁ is a 5-membered ring, a 6-membered ring, a condensed ring in which 2 or more 5-membered rings are condensed with each other, a condensed ring in which 2 or more 6-membered rings are condensed with each other, or a condensed ring in which 1 or more 5-membered rings and 1 or more 6-membered rings are condensed with each other; and/or
wherein CY₁ is a 5-membered saturated cyclic group or a 6-membered saturated cyclic group.

6. The etching composition of claims 4 or 5, wherein Z₁ to Z₆, Z₁₁ and Z₁₂ are each independently:
hydrogen, deuterium, *-F, *-Cl, *-Br, *-I, *-OH, *-SH, *-NH₂, *-C(=O)H, *-C(=S)H, *-C(=O)-OH, *-C(=S)-OH, *-C(=O)-SH, *-C(=S)-SH, *-C(=O)-(NH₂), *-C(=S)-(NH₂), *-NH-C(=O)-(NH₂), *-NH-C(=S)-(NH₂), *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH, *-C(=S)-C(=S)-SH, or *-C(=O)-ONH₄; or
a C₁-C₂₀ alkyl group or a C₇-C₂₀ arylalkyl group, each unsubstituted or substituted with deuterium, *-F, *-CI, *-Br, *-I, *-OH, *-SH, *-NH₂, *-C(=O)H, *-C(=S)H, *-C(=O)-OH, *-C(=S)-OH, *-C(=O)-SH, *-C(=S)-SH, *-C(=O)-(NH₂), *-C(=S)-(NH₂), *-NH-C(=O)-(NH₂), *-NH-C(=S)-(NH₂), *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH, *-C(=S)-C(=S)-SH, *-C(=O)-ONH₄, or any combination thereof.

7. The etching composition of any of claims 2-6, wherein the first compound is one of Compound 1-E1 to Compound 1-E16 and Compound 2-E1 to Compound 2-E32 below:

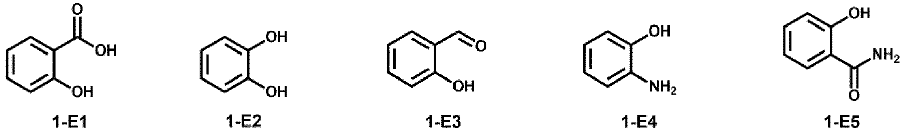

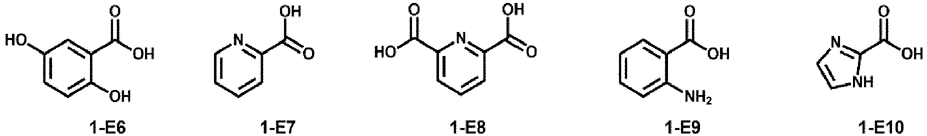

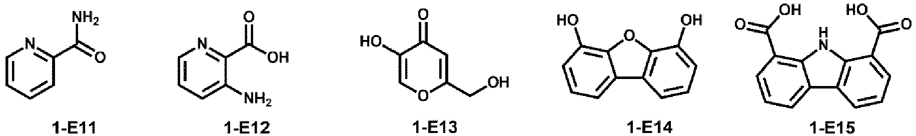

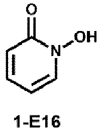

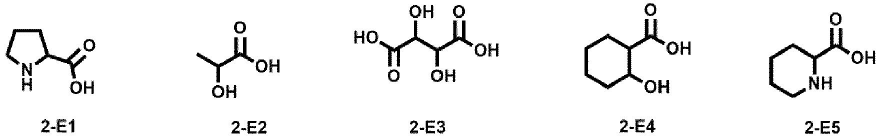

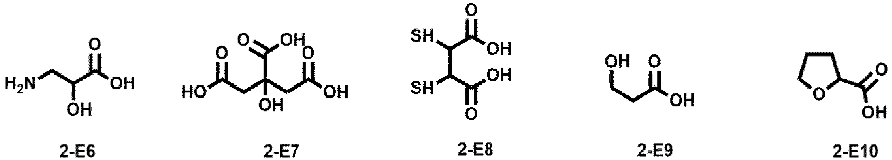

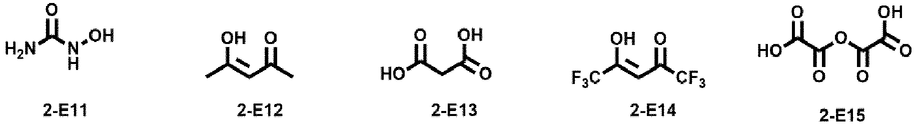

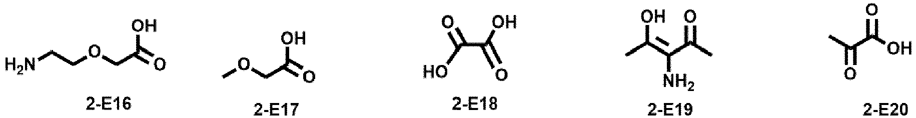

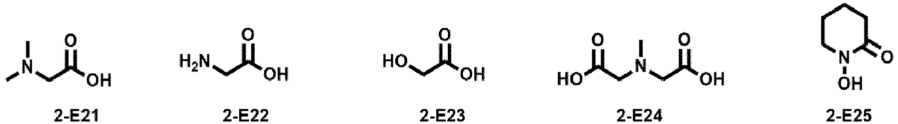

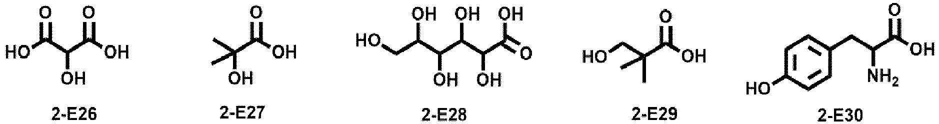

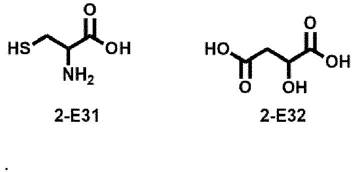

8. The etching composition of any of claims 2-7, wherein the second compound is a compound represented by one of Formula 3-1 to Formula 3-5 below: 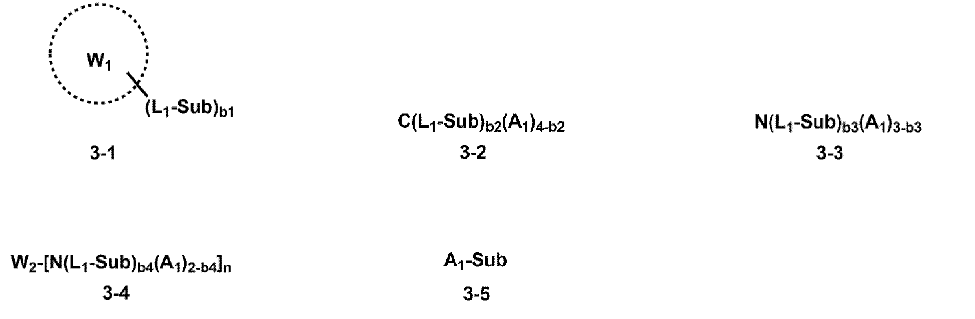 wherein, in Formula 3-1 to Formula 3-5,
W₁ is a C₃-C₂₀ cyclic group that is unsubstituted or substituted with at least one Z1,
W₂ is a C₁-C₂₀ aliphatic hydrocarbon group that is unsubstituted or substituted with at least one Z₁,
L₁ is: a single bond; or a C₁-C₂₀ alkylene group or a C₂-C₂₀ alkenylene group, each unsubstituted substituted with at least one Z₁,
Sub is a group represented by Formula A, a group represented by Formula B, or a group represented by Formula C,
A₁ is the same as defined in claim 1,
b1 is an integer from 1 to 10,
b2 is an integer from 1 to 4,
b3 is an integer from 1 to 3,
b4 is 1 or 2,
n is an integer from 1 to 5,
Z₁ is
hydrogen, deuterium, *-F, *-CI, *-Br, *-I, *-OH, *-SH, *-NH₂, *-C(=O)H, *-C(=S)H, *-C(=O)-OH, *-C(=S)-OH, *-C(=O)-SH, *-C(=S)-SH, *-C(=O)-(NH₂), *-C(=S)-(NH₂), *-NH-C(=O)-(NH₂), *-NH-C(=S)-(NH₂), *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH, *-C(=S)-C(=S)-SH, or *-C(=O)-ONH₄, or
a C₁-C₂₀ alkyl group, a C₂-C₂₀ alkenyl group, a C₁-C₂₀ alkoxy group, a C₆-C₂₀ aryl group, a C₂-C₂₀ heteroaryl group, a C₇-C₂₀ arylalkyl group, or a C₃-C₂₀ heteroarylalkyl group, each unsubstituted or substituted with deuterium, *-F, *-Cl, *-Br, *-I, *-OH, *-SH, *-NH₂, *-C(=O)H, *-C(=S)H, *-C(=O)-OH, *-C(=S)-OH, *-C(=O)-SH, *-C(=S)-SH, *-C(=O)-(NH₂), *-C(=S)-(NH₂), *-NH-C(=O)-(NH₂), *-NH-C(=S)-(NH₂), *-C(OH)-C(=O)-OH, *-C(SH)-C(=O)-OH, *-C(OH)-C(=S)-OH, *-C(OH)-C(=O)-SH, *-C(SH)-C(=S)-OH, *-C(SH)-C(=O)-SH, *-C(OH)-C(=S)-SH, *-C(SH)-C(=S)-SH, *-C(=O)-C(=O)-OH, *-C(=S)-C(=O)-OH, *-C(=O)-C(=S)-OH, *-C(=O)-C(=O)-SH, *-C(=S)-C(=S)-OH, *-C(=S)-C(=O)-SH, *-C(=O)-C(=S)-SH, *-C(=S)-C(=S)-SH, *-C(=O)-ONH₄, or any combination thereof, and
* is a binding site with a neighboring atom.

9. The etching composition of claim 8, wherein W₁ is a benzene group, a cyclohexane group, a pyridine group, or a pyrrolidine group.

10. The etching composition of any of claims 2-9, wherein the second compound is one of Compound 3-E1 to Compound 3-E14 below:

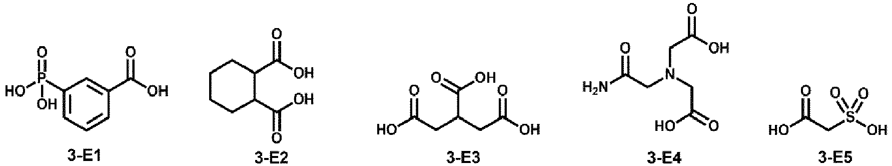

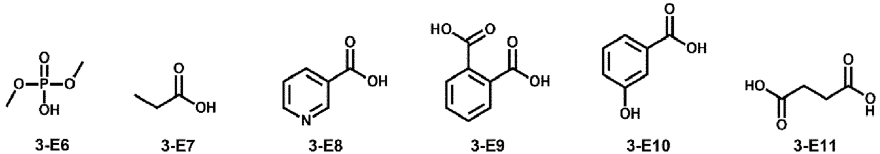

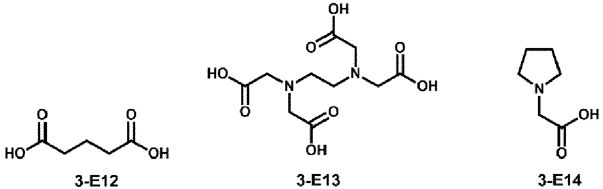

11. The etching composition of any of claims 1-10, wherein a weight ratio of the first accelerator to the second accelerator is 1:99 to 99:1; and/or
wherein an amount of the accelerator is 0.001 wt% to 20 wt%, per 100 wt% of the etching composition.

12. A method of etching a metal-containing film or manufacturing a semiconductor device, the method comprising:
preparing a substrate on which a metal-containing film is provided; and
performing an etching process using the etching composition of any of claims 1-11 on the metal-containing film to remove at least a portion of the metal-containing film.

13. The method of claim 12, wherein the metal-containing film comprises indium (In), titanium (Ti), aluminum (Al), lanthanum (La), scandium (Sc), gallium (Ga), zinc (Zn), hafnium (Hf), or any combination thereof; and/or
wherein the metal-containing film comprises a metal nitride, a metal oxide, a metal oxynitride, or a combination thereof.

14. The method of claims 12 or 13, wherein
the metal-containing film comprises a first region and a second region,
a second etching rate at which the etching composition etches the second region is greater than a first etching rate at which the etching composition etches the first region, and
the etching process is performed by contacting at least a portion of the first region and at least a portion of the second region with the etching composition;
preferably wherein the etching composition is configured to etch at least a portion of the first region and at least a portion of the second region, respectively.

15. The method of claim 14, wherein each of the first region and the second region comprises:
i) titanium nitride,
ii) titanium nitride further comprising at least one of indium, aluminum, lanthanum, scandium, gallium, zinc, hafnium, or any combination thereof, or
iii) a combination thereof.
